Europäisches Patentamt

European Patent Office

Office européen des brevets

(19)

(11) EP 0 543 730 B1

(12)

# FASCICULE DE BREVET EUROPEEN

(45) Date de publication et mention
de la délivrance du brevet:
**14.08.1996 Bulletin 1996/33**

(51) Int Cl.⁶: **H03M 1/12**

(21) Numéro de dépôt: **92403107.3**

(22) Date de dépôt: **18.11.1992**

(54) **Convertisseur analogique-numérique neuronique**

Neuronaler Analog-/Digitalwandler

Neural analogue-digital converter

(84) Etats contractants désignés:
**DE GB**

(30) Priorité: **22.11.1991 FR 9114435**

(43) Date de publication de la demande:
**26.05.1993 Bulletin 1993/21**

(73) Titulaire: **FRANCE TELECOM**
**75015 Paris (FR)**

(72) Inventeurs:
• **Collobert, Daniel**
 **F-22300 Lannion (FR)**
• **Collin, Olivier**
 **F-22300 Lannion (FR)**

(74) Mandataire: **Plaçais, Jean-Yves et al**
**Cabinet Netter,**
**40, rue Vignon**
**75009 Paris (FR)**

(56) Documents cités:
• **PROCEEDINGS OF THE 32ND MIDWEST SYMPOSIUM ON CIRCUITS AND SYSTEMS 14 Août 1989, CHAMPAIGN ILLINOIS US pages 497 - 500 SCULLEY ET AL 'A NEURAL NETWORK APPROACH TO HIGH PERFORMANCE ANALOG CIRCUIT DESIGN'**

## Description

L'invention concerne les convertisseurs analogiques-numériques.

Certaines applications nécessitent des convertisseurs analogiques-numériques rapides. C'est le cas notamment en imagerie médicale, et en télévision, plus particulièrement en télévision à haute définition.

Les convertisseurs analogiques-numériques qui sont actuellement les plus rapides sont ceux dénommés "flash", sur lesquels on reviendra plus loin. Ces convertisseurs sont fondés sur des circuits spécialisés, difficiles à fabriquer, et par conséquent onéreux.

Dans les convertisseurs flash déjà cités, les moyens de traitement sont essentiellement constitués d'une batterie de comparateurs montés en parallèle, et opérant chacun sur une fraction respective de la tension de référence.

On connaît, par ailleurs, d'après une publication de SCULLEY et al. "A neural network approach to high performance analog circuit design", Proceedings of the 32nd midwest symposium on circuits and systems", Champaign, Illinois (USA), pages 497-500 14 août 1989, des variantes de convertisseurs "flash" appelées convertisseur A/N de type "perceptron à N couches".

De tels convertisseurs comprennent :

- une entrée de signal analogique,
- une source de tension de référence,
- des moyens de traitement combiné du signal analogique et de la tension de référence, lesdits moyens de traitement comportant au moins un niveau d'opérateurs de traitement propres à effectuer un calcul non linéaire à partir de leurs entrées,
- des moyens codeurs pour fournir un signal numérique de sortie fonction des résultats de ce traitement, lesdits moyens codeurs comportant un niveau d'opérateurs de sortie.

Ces variantes de convertisseurs "flash" restent, cependant, fort compliquées, encombrantes en raison de l'utilisation d'une batterie de comparateurs montés en série, et difficiles à mettre en oeuvre.

Un premier but de l'invention est donc de permettre la réalisation d'un convertisseur analogique-numérique qui soit à la fois rapide et plus facile à fabriquer. En améliorant le taux de réussite en fabrication, on diminue par là même le coût du convertisseur.

Pour ce faire, l'invention va à l'opposé de ce qui est connu, en faisant usage de blocs fonctionnels dits "opérateurs", et que l'on pourra appeler également "neurones formels".

Selon une caractéristique essentielle de l'invention, d'une part, chaque opérateur de sortie possède autant d'entrées qu'il y a de sorties dans le dernier niveau d'opérateurs des moyens de traitement, et d'autre part, chaque opérateur de traitement et chaque opérateur de sortie possèdent une fonction de tranfert propre, choisie pour permettre une conversion analogique-numérique optimale sur un intervalle donné de valeurs de signaux d'entrée.

On décrira plus loin un procédé permettant de réaliser cette optimisation. L'optimisation porte d'abord sur l'obtention de la conversion analogique-numérique proprement dite; très avantageusement, elle tient compte aussi de la technologie utilisée pour la fabrication des circuits.

Très avantageusement, les opérateurs de traitement effectuent une combinaison pondérée de leurs entrées, puis une transformation de cette combinaison par une fonction non linéaire, qui doit être continue et dérivable, en principe. En conséquence, les "fonctions de transfert" précitées comprennent d'une part la réalisation de la combinaison pondérée, d'autre part l'application de la fonction de transformation, linéaire ou non.

De leur côté, les opérateurs de sortie effectuent également une combinaison pondérée de leurs entrées, suivie d'une transformation de cette combinaison pondérée par une fonction, qui est également en principe continue et dérivable, mais peut être soit linéaire soit non linéaire.

Dans un mode de réalisation avantageux, les opérateurs sont construits comme des amplificateurs opérationnels à entrées multiples. Les caractéristiques propres de ces amplificateurs opérationnels définissent ladite fonction de transformation continue, dérivable, avec sa non-linéarité là où elle est nécessaire. On peut alors ajuster les coefficients de pondération en jouant sur les résistances de contre-réaction et d'entrée dont est muni chaque amplificateur.

Selon un autre aspect de l'invention, les fonctions de transfert des opérateurs de traitement et des opérateurs de sortie sont choisies pour permettre une conversion analogique-numérique en un code, tel que le code Gray, où un seul bit change à la fois. Il peut alors être utile d'adjoindre aux moyens codeurs un transcodeur du code Gray en code numérique standard.

Le dispositif selon l'invention convient particulièrement bien pour réaliser une conversion analogique-numérique non linéaire, en particulier logarithmique.

Dans un autre mode de réalisation, les moyens de traitement comprennent au moins deux niveaux d'opérateurs, les opérateurs de chaque niveau étant reliés à tous les opérateurs du niveau précédent. Les opérateurs de l'un au moins de ces niveaux sont non linéaires.

L'invention offre également un procédé de conversion analogique-numérique.

Ce procédé consiste tout d'abord à prévoir un circuit comprenant une entrée de signal analogique, une source de tension de référence, au moins un niveau d'opérateurs de traitement propres à effectuer un calcul non linéaire à partir de leurs entrées, et un niveau d'opérateurs de sortie possédant chacun autant d'entrées qu'il y a de sorties dans le dernier niveau d'opérateurs des moyens de traitement, lesdits opérateurs de traitement et opérateurs de sortie possédant chacun une fonction de tranfert propre.

L'étape suivante consiste à initialiser les fonctions de transfert des opérateurs de traitement et des opérateurs de sortie à des valeurs choisies, qui peuvent être définies de manière aléatoire.

L'étape suivante consiste à présenter un signal analogique connu à l'entrée analogique. On évalue ensuite par une fonction de distance prédéterminée l'écart entre le signal numérique de sortie réel et sa valeur désirée. Après cela, on ajuste par rétropropagation du gradient les fonctions de transfert des opérateurs de traitement et des opérateurs de sortie pour minimiser cette fonction de distance.

Ces trois étapes sont répétées pour d'autres valeurs du signal analogique d'entrée.

On peut alors enfin fixer les fonctions de transfert des opérateurs de traitement et des opérateurs de sortie pour minimiser les fonctions de distance sur l'ensemble des signaux analogiques d'entrée.

D'autres caractéristiques et avantages de l'invention apparaîtront à l'examen de la description détaillée ci-après, et des dessins annexés, sur lesquels :

- la figure 1 est le schéma de principe d'un convertisseur flash de la technique antérieure;

- la figure 2 est le schéma de principe d'un opérateur ou neurone formel utilisé selon la présente invention;

- la figure 3 illustre l'allure d'une fonction non linéaire continue, dérivable, monotone et croissante, utilisable dans l'opérateur de la figure 2;

- la figure 4 illustre le schéma de principe d'un convertisseur analogique-numérique neuronique selon la présente invention;

- la figure 5 illustre plus particulièrement un convertisseur analogique selon l'invention, fonctionnant sur deux bits, donné à titre d'exemple illustratif;

- la figure 6 est un tableau illustrant des valeurs de pondération utilisables dans le convertisseur de la figure 5;

- la figure 7 est le schéma de principe d'une réalisation du convertisseur des figures 5 et 6 par amplificateur opérationnel;

- la figure 8 est un diagramme illustrant la définition d'une distance quadratique et un mode d'optimisation selon l'invention;

- la figure 9 est un diagramme montrant comment l'optimisation selon l'invention converge;

- la figure 10 est une variante de réalisation du convertisseur selon l'invention avec deux niveaux dans les moyens de traitement;

- la figure 11 est un diagramme illustrant un autre avantage de l'invention;

- la figure 12 est un ensemble de diagrammes illustrant la réalisation d'un code Gray par un convertisseur selon l'invention; et

- la figure 13 est un autre diagramme illustrant le résultat de l'optimisation selon l'invention.

Les dessins annexés sont pour l'essentiel de caractère certain. En conséquence, ils sont à considérer comme partie intégrante de la présente description. Ils pourront donc servir non seulement à mieux faire comprendre celle-ci, mais aussi pour contribuer à la définition de l'invention, le cas échéant.

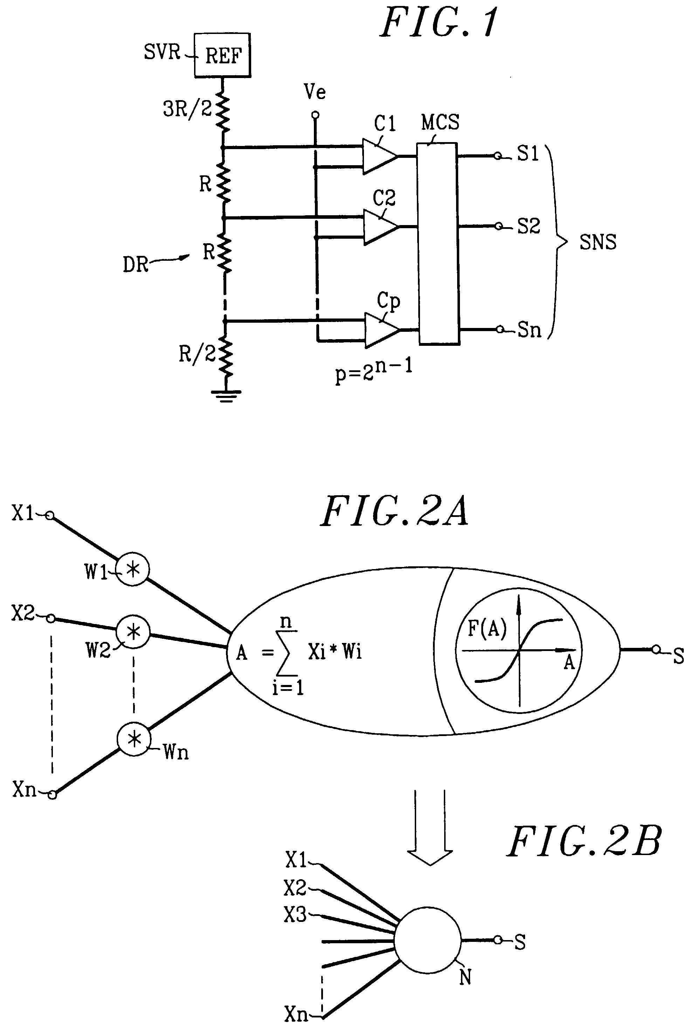

La figure 1 illustre la structure générale d'un convertisseur flash de la technique antérieure.

Une source SVR fournit une tension de référence REF, appliquée à un diviseur résistif DR. Comme il est classique, ce diviseur résistif commence par une résistance de valeur 3R/2, pour se poursuivre avec des résistances de valeur R, et se terminer sur une résistance de pied dont la valeur est R/2.

Le nombre de points intermédiaires de ce diviseur résistif est noté p. Ces p points intermédiaires sont reliés respectivement à une entrée de p comparateurs C1 à Cp, dont chacun reçoit sur son autre entrée le signal d'entrée Ve, qui est la tension analogique à convertir.

Les sorties des comparateurs C1 à Cp sont appliquées à un module codeur de sortie MCS, qui va instantanément délivrer une sortie sur n fils S1 à Sn, l'ensemble formant un signal numérique de sortie SNS exprimé sur n bits. L'homme de l'art sait que le nombre p de comparateurs nécessaires est égal à $2^{n-1}$.

L'avantage de ces convertisseurs flash est que la comparaison s'y effectue en une étape, et que le décodage de sortie est quasi-instantané. D'où la grande rapidité de ces convertisseurs. Mais, en contrepartie, la fabrication de ces convertisseurs est difficile, à cause du grand nombre de comparateurs qu'ils doivent comporter, et de la précision demandée à ceux-ci. D'où des difficultés de coût et de taux de réussite en fabrication sous forme de circuits intégrés.

Il est maintenant fait référence à la figure 2, qui se subdivise en une figure 2A et une figure 2B.

Sur la figure 2A, on a illustré des signaux analogiques d'entrée X1 à Xn (n n'ayant pas le même sens que précédemment). A chacun de ces signaux d'entrée est appliqué un facteur de pondération W1 à Wn. Les signaux ainsi obtenus sont alors sommés pour fournir un signal A. Et au signal A on applique une fonction F(A), qui peut être linéaire ou non linéaire. Est alors obtenu un signal de sortie S.

Le moyen ainsi défini sur la figure 2A, que l'on peut appeler opérateur élémentaire ou "neurone formel", sera symbolisé ici sous la forme illustrée à la figure 2B. Sur les dessins, la lettre N illustre un tel neurone formel. Elle sera suivie d'un premier chiffre indiquant le niveau dans lequel se trouve le neurone formel à l'intérieur du dispositif selon l'invention, et d'un second chiffre indiquant le rang du neurone formel dans ce niveau.

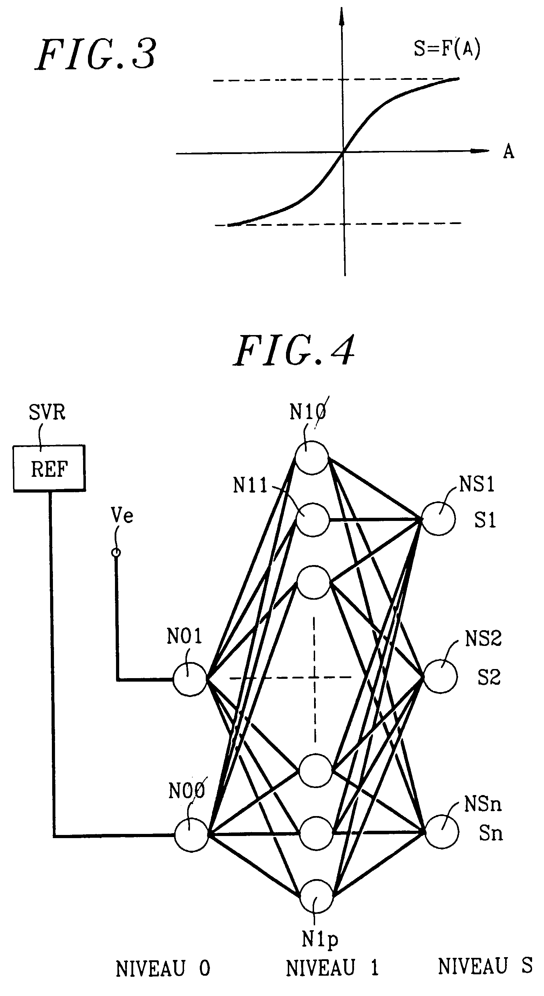

La figure 3 illustre une forme de fonction F(A) qui possède la propriété d'être non linéaire, en même temps que continue et dérivable. Les Demandeurs estiment en effet que, dans le cas où l'opérateur élémentaire possède une fonction de transformation non linéaire, celle-ci doit être continue et dérivable pour le bon fonctionnement du dispositif selon l'invention. Cependant, si la pente maximale de cette fonction de transformation doit être assez basse pour le processus d'apprentissage, elle peut être beaucoup plus élevée dans le circuit finalement réalisé, jusqu'à atteindre pratiquement une fonction de seuil ou "échelon". De façon a priori inattendue, les Demandeurs ont observé qu'il est possible de réaliser un convertisseur analogique-numérique, en utilisant un certain nombre d'opérateurs (dont certains au moins vont opérer en mode non linéaire) mais qui sont à la base simples et tous identiques, et sont reliés entre eux pour former au moins trois couches ou niveaux. Le niveau d'entrée comporte un seul opérateur recevant la tension à convertir, et éventuellement un autre opérateur recevant la tension de référence. Le niveau de sortie comporte un nombre d'opérateurs égal au nombre de bits désiré. Le ou les niveau(x) intermédiaire(s) comporte(nt) plusieurs opérateurs, dont chacun va recevoir une valeur de référence, qui est proportionnelle à la tension de référence de conversion.

Ainsi, sur la figure 4, on trouve au niveau zéro les opérateurs élémentaires N01 et N00, qui reçoivent respectivement la tension d'entrée et la tension de référence.

Au niveau 1 sont définis des opérateurs N10 à N1p. Au niveau de sortie S se trouvent les opérateurs NS1 à NSn, qui fournissent respectivement les bits de sortie S1 à Sn.

Les opérateurs du niveau 0 ne sont pas nécessairement non linéaires. Le niveau 1 peut comporter en fait un ou plusieurs sous-niveaux. Au moins l'un d'entre eux possède des opérateurs non linéaires.

Les opérateurs du niveau de sortie S peuvent être soit linéaires soit non linéaires.

Dans un mode de réalisation préférentiel, tous les opérateurs sont réalisés sur la base du même circuit, qui est constitué par un sommateur appliquant ensuite une fonction sur la somme pondérée de ses entrées. Il serait toutefois envisageable d'utiliser plus généralement tout opérateur possédant une fonction de transfert appropriée pour la mise en oeuvre de l'invention.

En ce qui concerne la fonction F(A), la forme exacte de cette fonction n'a pas une importance très grande, pourvu qu'elle soit continue et dérivable comme déjà mentionné. Il est préférable, mais non absolument impératif, que cette fonction soit en outre monotone.

Très avantageusement, cette fonction est choisie comme étant la fonction de transfert du composant et du dispositif choisis pour la mise en oeuvre physique de l'opérateur élémentaire ou neurone formel. La réalisation matérielle du convertisseur analogique-numérique se trouve alors grandement simplifiée.

Ainsi, par exemple, dans les réalisations à amplificateur opérationnel que l'on décrira plus loin à titre illustratif, la sommation pondérée est réalisée sur les entrées d'un amplificateur opérationnel. La courbe de réponse de l'amplificateur opérationnel, compte tenu d'une éventuelle saturation, peut définir soit une fonction F linéaire, soit une fonction F non linéaire.

A partir de là, il s'est avéré possible de calculer les différentes valeurs des pondérations W, à partir de la connaissance que l'on a des valeurs que doivent prendre les sorties en fonction des différentes entrées. Ce processus, que l'on peut qualifier d'apprentissage, peut notamment être réalisé d'une manière que l'on décrira plus loin.

On notera au passage que l'ensemble des jeux de valeurs de pondération qui permettent de réaliser un convertisseur n'est pas unique. Toutefois, toutes les solutions ne sont pas équivalentes en ce qui concerne l'insensibilité aux imprécisions des composants. L'homme du métier devra donc tester les résultats obtenus en fonction de critères tels que l'imprécision des composants, et choisir la meilleure configuration pour optimiser la fabrication du convertisseur analogique-numérique proposé.

Ce convertisseur devient très compliqué lorsqu'on veut qu'il travaille sur un nombre de bits élevé. En conséquence, l'exemple qui va être donné ci-après se réduit à un convertisseur analogique-numérique à deux bits.

La figure 5 illustre un tel convertisseur, où l'on retrouve les opérateurs d'entrée N00 et N01 respectivement pour le signal de référence et le signal à convertir.

La première couche est constituée d'opérateurs N10 à N13. L'opérateur N10 est limité à la tension de référence. Les opérateurs N11 à N13 sont liés aux signaux issus des opérateurs N01 et N00.

Enfin, les deux opérateurs de sortie NS1 et NS2 reprennent toutes les sorties des opérateurs N10 à N13 pour fournir une sortie sur deux bits, comme annoncé.

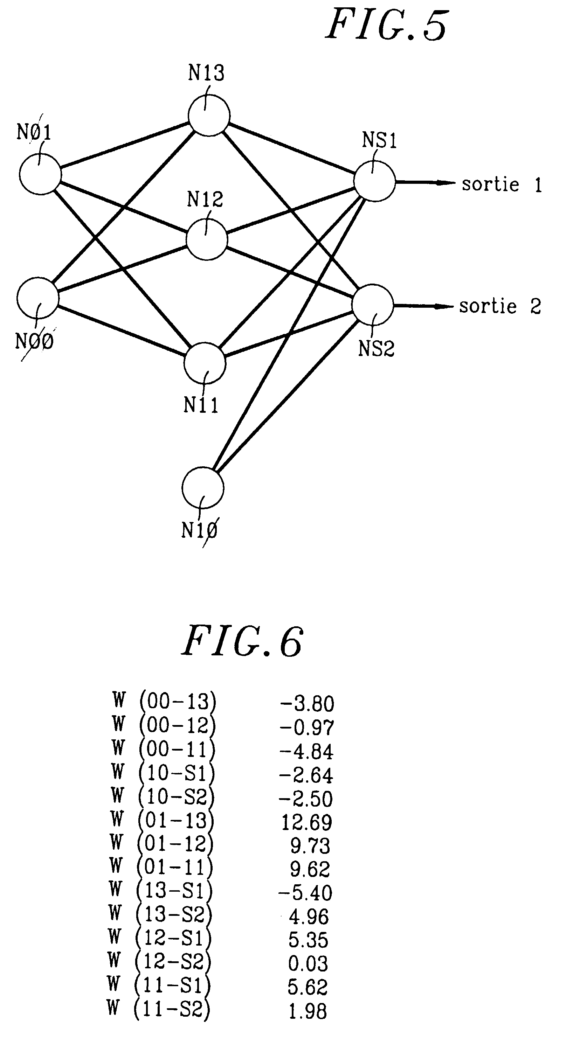

La figure 6 illustre à titre d'exemple un jeu de coefficients de pondération qui a pu être obtenu pour un tel convertisseur. Ces coefficients W sont exprimés de la manière suivante : dans la parenthèse, on indique d'abord le neurone amont d'où vient le signal, puis, après un tiret, le neurone qui reçoit le signal en question en lui affectant le coefficient de pondération W concerné.

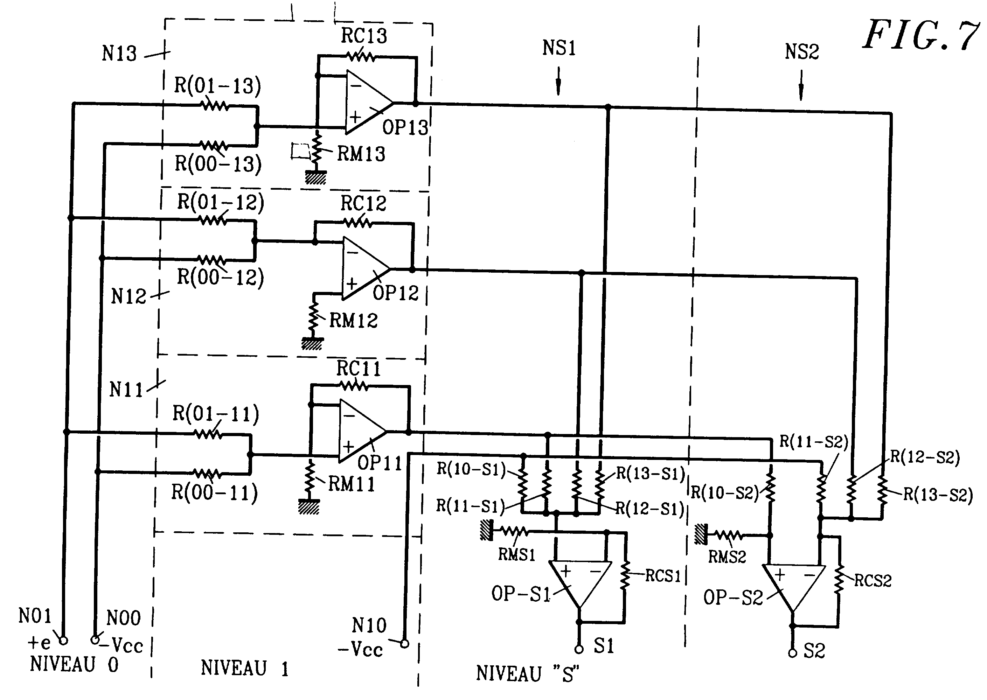

La figure 7 illustre un autre exemple, sous la forme d'un schéma détaillé d'un convertisseur à deux bits fondé sur des amplificateurs opérationnels. La tension à convertir est notée +E. La tension de référence est la tension d'alimentation des amplificateurs opérationnels, notée -Vcc, suivant une notation habituelle des hommes du métier.

L'homme du métier observera que certains des amplificateurs opérationnels sont montés en sommateurs non inverseurs, d'autres en sommateurs inverseurs.

Par ailleurs, l'opérateur N10 se réduit à l'opérateur unité puisqu'il reprend purement et simplement la tension de référence -Vcc.

Enfin, les notations suivantes ont été prises : pour chaque amplificateur opérationnel :

- sa résistance de contre-réaction est notée RC suivie du numéro de l'opérateur, comme indiqué par exemple en RC13,

- la résistance qui va de l'une des entrées vers la masse est notée RM également suivie du numéro de l'opérateur comme RM13,

- quant aux résistances sur les entrées actives, elles sont désignées de la même manière que les facteurs de pondération W précédemment, c'est-à-dire par une parenthèse où l'on indique d'abord le numéro de l'opérateur d'où vient le signal, puis après un tiret celui de l'opérateur recevant le signal, comme R(01-13).

Ces notations n'ont pas toutes été portées sur la figure 7 pour éviter d'alourdir le dessin.

Dans un exemple particulier, les amplificateurs opérationnels sont le modèle LF 353 vendu par MOTOROLA. Ils opèrent la conversion entre 0 et Vcc, avec en outre une tension de référence SVR = - Vcc. La non-linéarité de la fonction de transformation est obtenue d'un côté, par la non-linéarité au voisinage inférieur de la saturation des amplificateurs, de l'autre par leur non-linéarité au voisinage de l'entrée nulle.

Les valeurs des résistances sont les suivantes :

Opérateur N10 :

RC10 et RN10 égales à l'unité (en fait inexistantes puisqu'un amplificateur opérationnel n'est pas nécessaire),

R(01-10) infini,
R(00-10) égale à l'unité.

Opérateur N11 :

RC11=        13 260 ohms
RM11=        1 000 ohms
R(00-11)=    100 000 ohms
R(01-11)=    1 330 ohms

Opérateur N12 :

RC12=        91 000 ohms

RM12=          1 000 ohms
R(00-12)=       28 310 ohms
R(01-12)=       5 000 ohms

Opérateur N13 :

RC13=          14 970 ohms
RM13=          1 000 ohms
R(00-13)=       10 000 ohms
R(01-13)=       2 210ohms

Opérateur NS1 :

RCS1=          36 850 ohms
RMS1=          1 000 ohms
R(10-S1)=       6 730 ohms
R(11-S1)=       9 380 ohms
R(12-S1)=       10 000 ohms
R(13-S1)=       8 150 ohms

Opérateur NS2 :

RCS2=          10 000 ohms
RMS2=          10 000 ohms
R(10-S2)=       5 980 ohms
R(11-S2)=       32 830 ohms
R(12-S2)=       1 320 ohms
R(13-S2)=       23 810 ohms

L'homme du métier sait retrouver les facteurs de pondération W correspondant à ces valeurs de résistance.

Des essais ont été faits avec le convertisseur analogique-numérique qui vient d'être décrit. Il s'est avéré que sa réponse était tout à fait satisfaisante. Par ailleurs, comme déjà indiqué, les valeurs à respecter pour les pondérations W ne sont pas imposées avec une grande précision. Ceci est particulièrement important pour la fabrication en série sous la forme d'un circuit intégré.

En outre, des essais de simulation ont été effectués de la manière suivante:

i) on part d'une structure de convertisseur ayant exactement les coefficients de pondération optimaux calculés ;
ii) on altère ces coefficients de pondération, proportionnellement, en fonction d'un bruitage gaussien ;
iii) on effectue (en simulation) des conversions analogiques-numériques avec ces coefficients altérés ;
iv) on détermine les conversions à rejeter comme incorrectes, en fonction des types d'erreurs ci-dessous :

- au moins une erreur supérieure à plus ou moins la moitié du bit le moins significatif,
- au moins une erreur supérieure à plus ou moins la valeur du bit le moins significatif,
- au moins un saut de code (de bit) indu,
- convertisseur dont la réponse n'est pas monotone.

v) on répète X fois les opérations ii) à iv), avec à chaque fois un nouveau bruitage gaussien indépendant des précédents, en d'autres termes une nouvelle estimation d'écarts aléatoires sur les coefficients de pondération.

Après X = 100 répétitions, on a recherché quel était le pourcentage de convertisseurs qui devraient être rejetés, en distinguant le type d'erreur concerné.

Enfin, toutes ces opérations ont été conduites pour différentes valeur du rapport du bruitage gaussien, relativement aux valeurs des coefficients de pondération de l'étape i). Les résultats sont les suivants.

La monotonicité des convertisseurs est excellente, jusqu'à un taux de bruitage (une précision) de 10 % sur les coefficients de pondération.

60 % des convertisseurs analogiques-numériques ne font aucune erreur supérieure à plus ou moins la valeur du bit le moins significatif, tant que le taux de bruitage reste inférieur à 10%.

50 % des convertisseurs analogiques-numériques ne présentent aucun saut de code indu, tant que le taux de bruitage reste inférieur à 10%.

50 % des convertisseurs analogiques-numériques ne présentent aucune erreur supérieure à plus ou moins la moitié du bit le moins significatif, tant que le taux de bruitage reste inférieur à environ 4,5 %.

Ces valeurs correspondent à un bon rendement en fabrication des convertisseurs selon l'invention.

En effet, si le cahier des charges du convertisseur refuse les erreurs égales au bit le moins significatif, mais admet celles égales à la moitié du bit le moins significatif, le rendement de fabrication est 50 % pour une tolérance de +/- 10 % sur les facteurs de pondération.

Si le cahier des charges du convertisseur refuse également les erreurs égales à la moitié du bit le moins significatif, le rendement de fabrication est 50 % pour une tolérance de +/- 4,5 % sur les facteurs de pondération.

De plus, en adaptant ce convertisseur analogique-numérique pour un code de sortie à deux bits de type Gray, c'est-à-dire dont un seul bit change à la fois, on minimise les effets des erreurs au moment d'un changement ou saut de bit. Là où il est nécessaire de convertir un tel code Gray en code numérique normal, l'homme de l'art sait que ceci peut s'effectuer à l'aide de simples opérations OU EXCLUSIF, à réponse instantanée ou très rapide.

A côté de cela, le convertisseur en code GRAY de l'invention ne nécessite que $2^{n-1}$ opérateurs, soit deux fois moins qu'un convertisseur flash-Gray ($2^n$-1).

Les Demandeurs ont également observé qu'avec la nouvelle structure de convertisseur proposée, les difficultés sont rencontrées surtout pour les valeurs élevées de la tension à convertir. En conséquence, le nouveau convertisseur proposé est particulièrement bien adapté à une conversion analogique-numérique non linéaire, et dont la croissance est inférieure à celle d'une fonction linéaire, comme c'est le cas en particulier pour la conversion logarithmique. En ce cas, la limite de "bruitage" tolérable sur la définition des coefficients de pondération est considérablement augmentée.

Par ailleurs, dans la mesure où les sorties des éléments non linéaires n'ont pas besoin d'atteindre leurs valeurs théoriques avec une grande précision, il est possible d'accélérer le fonctionnement du convertisseur proposé. En effet, on peut anticiper la présentation de l'échantillon suivant, par rapport au temps total nécessaire pour la stabilisation du montage sur l'échantillon précédent. Ceci permet de diminuer le temps apparent de conversion. En conséquence, le nouveau convertisseur analogique-numérique ici proposé peut fonctionner plus vite qu'un convertisseur flash classique, à performances de circuits comparables.

On donnera maintenant à titre d'exemple un mode de recherche des coefficients de pondération optimaux pour les convertisseurs selon l'invention.

Le problème consiste, partant d'une structure d'opérateurs élémentaires prédéterminée, à faire évoluer les coefficients de pondération de ceux-ci.

Pour une valeur donnée d'une tension d'entrée à convertir, la phase d'apprentissage va consister à observer la tension de sortie fournie par le montage pour un certain jeu de coefficients de pondération, et à faire évoluer ce jeu pour minimiser une fonction de "distance".

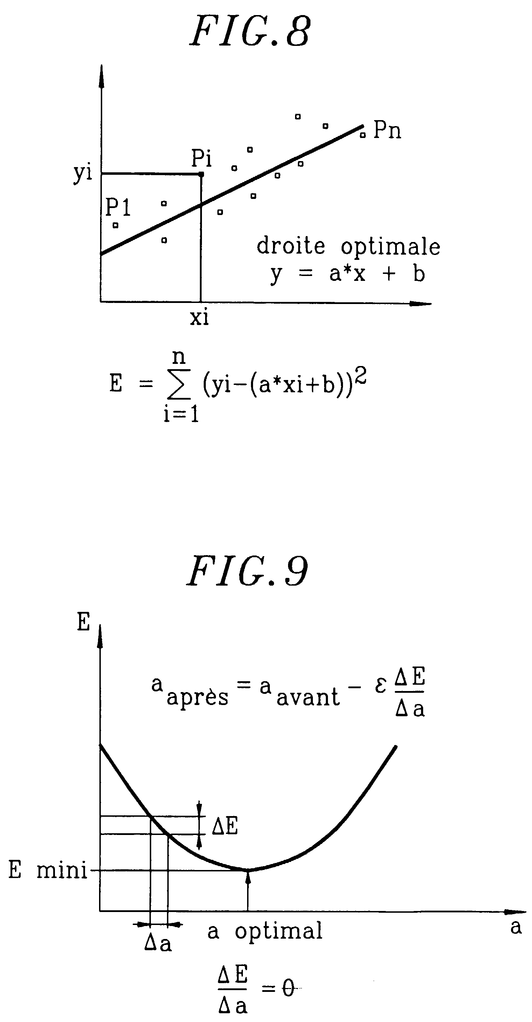

En admettant qu'il s'agit d'une conversion analogique-numérique linéaire, si la relation entrée-sortie recherchée est celle définie par la ligne droite des diagrammes de la figure 8, et qu'un convertisseur ayant un jeu de coefficients de pondération donnés fournit les points dispersés autour de cette ligne droite, on va rechercher une distance moyenne entre l'ensemble de ces points et la droite, par la formule donnée en dessous de la figure 8.

En réalité, ici, les paramètres a et b de la droite qui s'ajuste au mieux sur le nuage de points obtenu sont inconnus. Il faut donc les rechercher.

Le moyen ici proposé à cet effet est le procédé dit "descente du gradient".

Il s'agit tout d'abord de calculer un gradient, qui est la variation de l'erreur E en fonction de chacun des paramètres, c'est-à-dire des coefficients de pondération utilisés.

Pour chaque valeur de gradient obtenue, on cherche le "chemin de la descente" qui consiste à faire varier les paramètres par petits pas, dans le sens opposé à celui qui correspond au signe de la mesure du gradient. Ceci est effectué jusqu'à atteindre une valeur minimale de la distance E, qui correspond à un gradient nul.

Ce processus est illustré graphiquement sur la figure 9, où en abscisse on trouve le paramètre A, tandis qu'en ordonnée on trouve la mesure de distance E. La valeur optimale de a est obtenue au creux de la courbe de la figure 9. Si l'on part par exemple du point situé dans la partie descendante de gauche de cette courbe, on mesure le gradient de E par rapport à a, et l'on diminue a par des fractions successives de ce gradient, jusqu'à atteindre le "creux de la vallée", où le gradient est nul, comme indiqué sur le dessin.

Cette figure 9 illustre le cas où on n'aurait que deux paramètres a et b, comme lors de l'ajustement linéaire illustré sur la figure 8.

Avec le convertisseur analogique de la présente invention, les paramètres sont constitués de tous les poids W impliqués dans le réseau du circuit convertisseur.

En outre, il ne s'agit pas d'ajuster ces poids par rapport à une ligne droite, mais par rapport à une fonction bien plus compliquée.

Les formules exactes utilisées sont données dans l'annexe de formules qui se trouve à la fin de la présente description.

La formule (I) donne une forme de calcul de distance quadratique utilisable pour l'apprentissage du réseau.

Dans cette formule, d désigne la sortie désirée pour le convertisseur et $x_s$ la sortie mesurée, pour un exemple donné.

Les relations (II) définissent la formule d'évolution du gradient en vertu du procédé de descente du gradient, tel que défini plus haut sur un exemple simplifié.

Ces formules (II) exposent également que l'on considère que le gradient dépend à chaque fois de l'activation du neurone j de la couche qui se trouve en amont de Wij, et ce selon un facteur $e_i$ qui représente la portion d'erreur provenant de la couche aval.

Cette portion $e_i$ est donnée par la relation (III), où $F'(a_i)$ est la dérivée de la fonction non linéaire F prise au point $a_i$.

Ceci permet de calculer, pour chaque unité neuronale, une erreur $e_i$, en effectuant une opération analogue à la propagation des entrées x qui s'effectue à l'intérieur du réseau neuronal constituant le convertisseur.

L'erreur obtenue en sortie est finalement pondérée et répartie sur l'ensemble des unités.

Toutefois, la propagation de l'erreur s'effectue en réalité des sorties vers les entrées, ce qui peut être appelé "rétropropagation de l'erreur".

En conséquence, le gradient du paramètre Wij est donc le produit de la sortie du neurone amont $x_j$ par l'erreur de sortie du neurone aval $e_i$, cette erreur locale représentant la participation du neurone i à l'erreur totale de sortie.

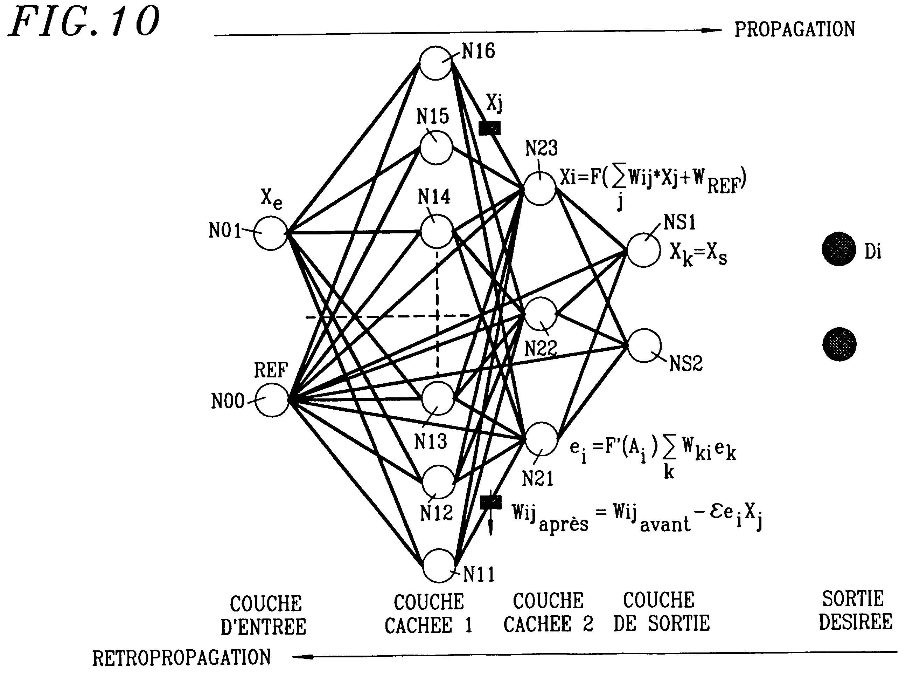

La figure 10 illustre cette analyse, en même temps que deux autres aspects de l'invention:

- cette figure 10 montre deux niveaux intermédiaires consécutifs entre le niveau d'entrée et le niveau de sortie ;
- elle montre aussi que des liaisons directes peuvent être prévues entre des niveaux non successifs dans certains cas. Ici, le neurone N00 est relié non seulement au niveau 1, mais aussi aux niveaux 2 et S. Ceci est équivalent à la présentation avec des neurones supplémentaires reliés à la tension de référence, comme l'est N10 sur la figure 5.

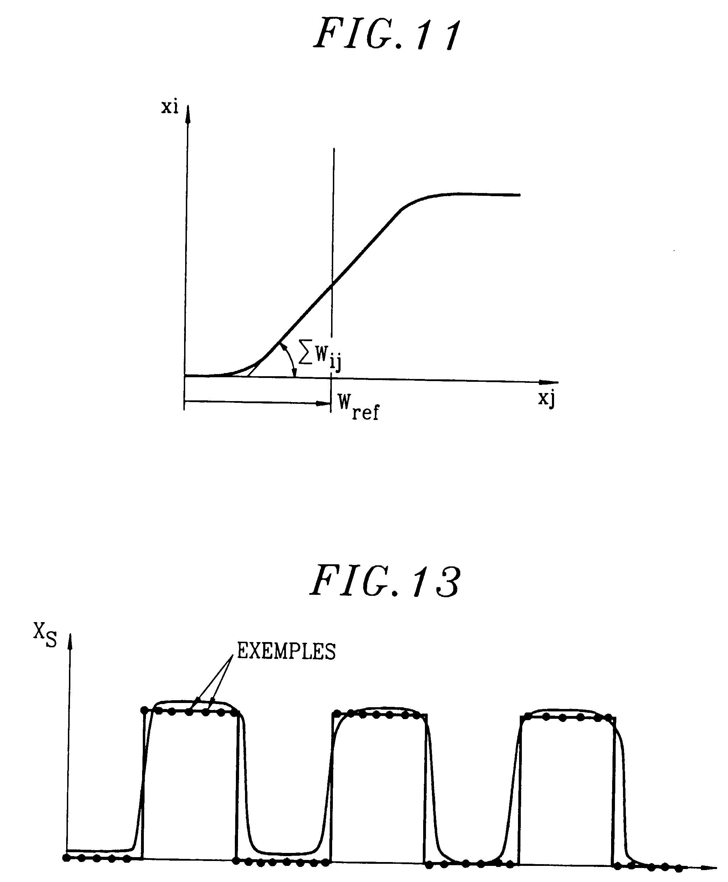

Dans ces conditions, chaque unité neuronale (des niveaux 1, 2 et S) peut être considérée comme connectée à une entrée supplémentaire de référence, dont l'activation vaut -1, et dont le poids Wref joue un rôle équivalent au a de la droite précitée, c'est-à-dire qu'il va avoir pour effet de translater globalement la fonction par rapport à l'origine. Au contraire, les autres poids interviennent globalement comme le p de la droite, en agissant sur la pente de la fonction. C'est ce qui est très schématiquement résumé dans le diagramme de la figure 11.

Bien que cet aspect ne semble pas rigoureusement impératif, il est considéré actuellement comme une aide particulièrement intéressante, facilitant considérablement l'apprentissage.

A partir de là, les Demandeurs ont observé qu'il est possible de réaliser l'apprentissage de la manière suivante :

a) initialisation des coefficients de pondération Wij à de faibles valeurs aléatoires, ce qui donne une valeur initiale de la fonction E;

b) pour chaque exemple (une valeur d'entrée, une valeur de sortie désirée, une valeur de sortie observée), on effectue :

b1) une propagation des entrées $x_e$, ce qui donne les sorties $x_s$, ainsi que l'erreur sur chaque sortie $E_s=(d-x_s)^2$,

b2) une rétropropagation de l'erreur $e_i$,

b3) le calcul du gradient $e_i * x_j$,

b4) la mise à jour des poids.

On calcule ainsi l'erreur totale de sortie sur l'ensemble des exemples. Si elle est suffisamment faible, on stoppe l'apprentissage. Sinon, on continue celui-ci, en reprenant les opérations b1) à b4).

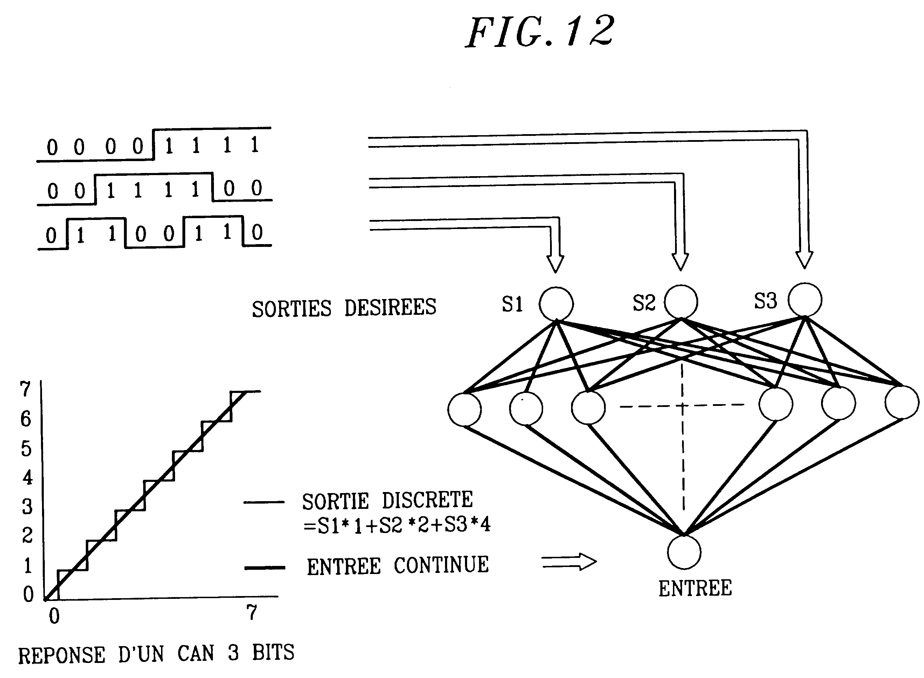

Lorsqu'il s'applique à un convertisseur analogique-numérique, le procédé d'apprentissage qui vient d'être décrit peut être schématisé comme illustré sur la figure 12, où l'on a d'une part la réponse désirée pour un convertisseur analogique-numérique à trois bits, exprimée sous la forme d'une sortie discrète à partir d'une entrée continue.

En partie droite, on trouve une structure neuronale propre à effectuer cette fonction.

Et en partie haute, en regard de chaque valeur de sortie, on a illustré les valeurs des trois bits de sortie correspondantes, ainsi que la forme d'onde de variation caractéristique du code Gray.

En d'autres termes, le réseau neuronal va chercher à approximer les fonctions de sortie de conversion analogique-numérique en utilisant un certain nombre de points comme exemple. Et les neurones peuvent alors être définis pour s'assembler de manière à reconstituer ces fonctions de sortie.

La figure 13 illustre un exemple de fonction des sorties obtenues à l'aide d'un tel apprentissage. On observera qu'elle correspond assez bien à la fonction de conversion analogique-numérique recherchée.

L'imperfection de la reconstruction représente l'erreur. Bien entendu, il est toujours possible de minimiser l'erreur, en augmentant le nombre d'unités neuronales utilisées.

Le nombre d'essais à effectuer en sera également fonction.

A partir du moment où l'on a satisfait la fonction de conversion analogique-numérique avec la précision recherchée, les poids peuvent être simplement mis en oeuvre dans un circuit, après quoi les neurones utilisés fonctionnent tous très simplement, de manière identique et en parallèle.

L'optimisation peut aussi devoir tenir compte des tolérances en fabrication sur la réalisation des coefficients de pondération.

De plus, les Demandeurs ont observé qu'une fois que l'apprentissage a été réalisé comme décrit plus haut, en utilisant la fonction de transformation "douce" illustrée sur la figure 3, la réalisation concrète peut être modifiée en lui substituant une fonction de transformation "abrupte", c'est à dire à seuil, encore dénommée "échelon" ou "marche d'escalier". Il peut en résulter une simplification de la réalisation, car les opérateurs fonctionnent alors en mode de commutation, plutôt qu'en amplification.

Il a été décrit un convertisseur opérant pour une seule polarité du signal d'entrée. L'homme du métier saura l'adapter si les deux polarités sont à traiter, par exemple en prenant des amplificateurs opérationnels avec alimentation symétrique, positive et négative.

Le mode de réalisation décrit en détail utilise la même tension comme référence de conversion et comme alimentation des amplificateurs opérationnels. En ce cas, l'utilisateur peut changer la référence sans que les coefficients de pondération ne doivent être modifiés. Si au contraire la tension de référence est différente de la tension d'alimentation des amplis opérationnels, alors, en général, il n'est pas possible de la changer sans changer les coefficients de pondération.

**ANNEXE    FORMULES**

$$(I) \qquad E\,(wij) = \sum_{\text{Exemples}} \left( \sum_{\text{Sorties}} (d - x_s)^2 \right)$$

$$(II) \qquad \begin{cases} w_{ij\ \text{Après}} = w_{ij\ \text{Avant}} - \varepsilon\ \partial E/\partial w_{ij} \\[2mm] \text{avec } \partial E/\partial w_{ij} = e_i x_j \end{cases}$$

$$(III) \qquad e_i = F'(a_i) \sum_k w_{ki}\, e_k$$

**Revendications**

1. Convertisseur analogique-numérique, comprenant:

   - une entrée de signal analogique (Ve),
   - une source de tension de référence (SVR),
   - des moyens de traitement combiné du signal analogique et de la tension de référence (DR, C1-Cp), lesdits moyens de traitement comportant au moins un niveau d'opérateurs de traitement (N0i, N1i) propres à effectuer un calcul non linéaire à partir de leurs entrées,
   - des moyens codeurs (MCS) pour fournir un signal numérique de sortie fonction des résultats de ce traitement, lesdits moyens codeurs comportant un niveau d'opérateurs de sortie (NSi),

   caractérisé en ce que chaque opérateur de sortie (NSi) posséde autant d'entrées qu'il y a de sorties dans le dernier niveau d'opérateurs des moyens de traitement, et en ce que chaque opérateur de traitement et chaque opérateur de sortie possèdent une fonction de tranfert propre, choisie pour permettre une conversion analogique-numérique optimale sur un intervalle donné de valeurs de signaux d'entrée.

2. Convertisseur analogique-numérique selon la revendication 1, caractérisé en ce que les opérateurs de traitement (N) effectuent une combinaison pondérée de leurs entrées, et transforment cette combinaison pondérée par une fonction non linéaire, continue et dérivable.

3. Convertisseur analogique-numérique selon la revendication 2, caractérisé en ce que les opérateurs de sortie (NS) effectuent une combinaison pondérée de leurs entrées, et transforment cette combinaison pondérée par une fonction linéaire ou non linéaire, continue et dérivable.

4. Convertisseur analogique-numérique selon l'une des revendications 2 et 3, caractérisé en ce que lesdits opérateurs sont contruits comme des amplificateurs opérationnels à entrées multiples.

5. Convertisseur analogique-numérique selon la revendication 4, caractérisé en ce que lesdites combinaisons pondérées sont ajustables.

6. Convertisseur analogique-numérique selon l'une des revendications 1 à 5, caractérisé en ce que les fonctions de transfert des opérateurs de traitement et des opérateurs de sortie sont choisies pour permettre une conversion analogique-numérique en un code, tel que le code GRAY, où un seul bit change à la fois.

7. Convertisseur analogique-numérique selon la revendication 6, caractérisé en ce que les moyens codeurs comprennent un transcodeur du code GRAY en code numérique standard.

8. Convertisseur analogique-numérique selon l'une des revendications 1 à 7, caractérisé en ce que les fonctions de transfert des opérateurs de traitement et des opérateurs de sortie sont choisies pour permettre une conversion analogique-numérique non linéaire, en particulier logarithmique.

9. Convertisseur analogique-numérique selon l'une des revendications 1 à 8, caractérisé en ce que les moyens de traitement comprennent au moins deux niveaux d'opérateurs, les opérateurs de chaque niveau étant reliés à tous les opérateurs du niveau précédent, et les opérateurs de l'un au moins de ces niveaux étant non linéaires.

10. Procédé de conversion analogique numérique, caractérisé par les étapes suivantes:

   a) prévoir un circuit comprenant une entrée de signal analogique (Ve), une source de tension de référence (SVR), au moins un niveau d'opérateurs de traitement (N) propres à effectuer un calcul non linéaire à partir de leurs entrées, et un niveau d'opérateurs de sortie (NS), possédant chacun autant d'entrées qu'il y a de sorties dans le dernier niveau d'opérateurs des moyens de traitement, lesdits opérateurs de traitement et opérateurs de sortie possédant chacun une fonction de tranfert propre,

   b) initialiser les fonctions de transfert des opérateurs de traitement et des opérateurs de sortie à des valeurs choisies,

   c) présenter un signal analogique connu à ladite entrée analogique (Ve),

   d) évaluer par une fonction de distance prédéterminée (E) l'écart entre le signal numérique de sortie réel et sa valeur désirée,

   e) ajuster par rétropropagation du gradient les fonctions de transfert des opérateurs de traitement et des opérateurs de sortie pour minimiser cette fonction de distance,

   f) répéter sélectivement les étapes c) à e) pour d'autres valeurs du signal analogique d'entrée, et

   g) fixer les fonctions de transfert des opérateurs de traitement et des opérateurs de sortie pour minimiser les fonctions de distance sur l'ensemble des signaux analogiques d'entrée présentés.

11. Procédé selon la revendication 10, caractérisé en ce que lesdites fonctions de transfert comprennent la réalisation d'une combinaison pondérée de leurs entrées, et la transformation de cette combinaison pondérée par une fonction continue et dérivable, et en ce que l'étape e) est restreinte à l'ajustement des coefficients de pondération.

12. Procédé selon la revendication 11, caractérisé en ce que ladite fonction de transformation est déterminée par la technologie de fabrication d'amplificateurs opérationnels.

**Patentansprüche**

1. Analog-/Digitalumsetzer, der folgendes aufweist:

   - einen Analogsignaleingang (Ve),
   - eine Bezugsspannungsquelle (SVR),
   - Einrichtungen zur kombinierten Verarbeitung des Analogsignals und der Bezugsspannung (DR, C1-Cp), wobei die Verarbeitungsmittel wenigstens eine Ebene von Verarbeitungsoperatoren (N0i, N1i) aufweisen, die zur Durchführung einer nichtlinearen Berechnung ausgehend von ihren Eingängen geeignet sind,
   - Codiereinrichtungen (MCS) zum Liefern eines digitalen Ausgangssignals in Abhängigkeit von den Ergebnissen dieser Verarbeitung, wobei die Codiereinrichtungen eine Ebene von Ausgangsoperatoren (NSi) aufweisen,

   dadurch gekennzeichnet, daß
   jeder Ausgangsoperator (NSi) so viele Eingänge besitzt, wie Ausgänge in der letzten Ebene von Operatoren der Verarbeitungseinrichtungen vorhanden sind, und daß jeder Verarbeitungsoperator sowie jeder Ausgangsoperator eine eigene Übertragungsfunktion besitzen, die derart gewählt ist, daß sie eine optimale Analog-/Digitalumsetzung über ein gegebenes Intervall von Eingangssignalwerten ermöglicht.

2. Analog-/Digitalumsetzer nach Anspruch 1,
   dadurch gekennzeichnet,
   daß die Verarbeitungsoperatoren (N) eine gewichtete Kombination ihrer Eingänge durchführen und diese gewichtete Kombination durch eine nichtlineare, kontinuierliche und ableitbare Funktion transformieren.

3. Analog-/Digitalumsetzer nach Anspruch 2,
   dadurch gekennzeichnet,
   daß die Ausgangsoperatoren (NS) eine gewichtete Kombination ihrer Eingänge durchführen und diese gewichtete Kombination durch eine nichtlineare, kontinuierliche und ableitbare Funktion transformieren.

4. Analog-/Digitalumsetzer nach einem der Ansprüche 2 und 3,
   dadurch gekennzeichnet,
   daß die Operatoren als Operationsverstärker mit Mehrfacheingängen aufgebaut sind.

5. Analog-/Digitalumsetzer nach Anspruch 4,
   dadurch gekennzeichnet,
   daß die gewichteten Funktionen einstellbar sind.

6. Analog-/Digitalumsetzer nach einem der Ansprüche 1 bis 5,
   dadurch gekennzeichnet,
   daß die Übertragungsfunktionen der Verarbeitungsoperatoren und der Ausgangsoperatoren derart gewählt sind, daß eine Analog-/Digitalumsetzung in einem Code wie dem Gray-Code ermöglicht wird, wo sich nur ein Bit auf einmal ändert.

7. Analog-/Digitalumsetzer nach Anspruch 6,
   dadurch gekennzeichnet,
   daß die Codiereinrichtungen einen Codeumsetzer für den Gray-Code in einen Standarddigitalcode aufweisen.

8. Analog-/Digitalumsetzer nach einem der Ansprüche 1 bis 7,
   dadurch gekennzeichnet,
   daß die Übertragungsfunktionen der Verarbeitungsoperatoren und der Ausgangsoperatoren derart gewählt sind, daß eine nichtlineare, insbesondere logarithmische Analog/Digitalumsetzung ermöglicht wird.

9. Analog-/Digitalumsetzer nach einem der Ansprüche 1 bis 8,
   dadurch gekennzeichnet,
   daß die Verarbeitungseinrichtungen wenigstens zwei Operatorebenen aufweisen, wobei die Operatoren jeder Ebene mit allen Operatoren der vorhergehenden Ebene verbunden sind und die Operatoren wenigstens einer dieser Ebenen nichtlinear sind.

10. Verfahren zur Analog-/Digitalumsetzung,

gekennzeichnet durch
die folgenden Schritte:

a) es wird eine Schaltung vorgesehen, die einen Analogsignaleingang (Ve), eine Bezugsspannungsquelle (SVR), wenigstens eine Ebene von Verarbeitungsoperatoren (N), die zur Durchführung einer nichtlinearen Berechnung ausgehend von ihren Eingängen geeignet sind, sowie eine Ebene von Ausgangsoperatoren (NS) aufweist, die jeweils so viele Ausgänge besitzen, wie Ausgänge in der letzten Ebene der Operatoren der Verarbeitungsmittel vorhanden sind, wobei die Verarbeitungsoperatoren sowie die Ausgangsoperatoren jeweils eine eigene Übertragungsfunktion besitzen,

b) die Übertragungsfunktionen der Verarbeitungsoperatoren und der Ausgangsoperatoren werden mit gewählten Werten initialisiert,

c) ein bekanntes Analogsignal wird an den Analogeingang (Ve) angelegt,

d) die Abweichung zwischen dem tatsächlichen Ausgangssignal und seinem gewünschten Wert wird durch eine vorbestimmte Abstandsfunktion (E) ausgewertet,

e) die Übertragungsfunktionen der Verarbeitungsoperatoren und der Ausgangsoperatoren werden zur Minimierung dieser Abstandsfunktion durch Rückfortpflanzung des Gradienten eingestellt,

f) die Schritte c) bis e) werden selektiv für andere Werte des analogen Eingangssignals wiederholt, und

g) die Übertragungsfunktionen der Verarbeitungsoperatoren und der Ausgangsoperatoren werden zur Minimierung der Abstandsfunktionen auf die Gesamtheit der angelegten Eingangssignale festgelegt.

**11.** Verfahren nach Anspruch 10,
dadurch gekennzeichnet,
daß die Übertragungsfunktionen die Durchführung einer gewichteten Kombination ihrer Eingänge sowie die Transformation dieser gewichteten Kombination durch eine kontinuierliche und ableitbare Funktion umfassen, und daß der Schritt e) auf die Einstellung der Gewichtungskoeffizienten beschränkt ist.

**12.** Verfahren nach Anspruch 11,
dadurch gekennzeichnet,
daß die Transformationsfunktion durch die Technologie der Herstellung von Operationsverstärkern bestimmt ist.

## Claims

**1.** Analogue-digital converter, comprising:

- an analogue signal input (Ve),
- a reference voltage source (SVR),
- processing means for the combined processing of the analogue signal and the reference voltage (DR, C1-Cp), the said processing means comprising at least one level of processing operators (N0i, N1i) capable of effecting a non-linear calculation on the basis of their inputs,
- coding means (MCS) for providing a digital output signal as a function of the results of that processing, the said coding means comprising a level of output operators (NSi),

characterised in that each output operator (NSi) possesses as many inputs as there are outputs in the final level of operators of the processing means, and in that each processing operator and each output operator has its own transfer function selected to permit optimum analogue-digital conversion at a given interval of input signal values.

**2.** Analogue-digital converter according to Claim 1, characterised in that the processing operators (N) effect a weighted combination of their inputs, and transform that weighted combination by a non-linear, continuous and differentiable function.

**3.** Analogue-digital converter according to Claim 2, characterised in that the output operators (NS) effect a weighted combination of their inputs, and transform that weighted combination by a linear or non-linear, continuous and differentiable function.

4. Analogue-digital converter according to either of Claims 2 and 3, characterised in that the said operators are constructed as multiple-input operational amplifiers.

5. Analogue-digital converter according to Claim 4, characterised in that the said weighted combinations are adjustable.

6. Analogue-digital converter according to any one of Claims 1 to 5, characterised in that the transfer functions of the processing operators and of the output operators are selected to permit analogue-digital conversion into a code, such as the GRAY code, where a single bit changes at a time.

7. Analogue-digital converter according to Claim 6, characterised in that the coding means comprise a transcoder of the GRAY code into standard digital code.

8. Analogue-digital converter according to any one of Claims 1 to 7, characterised in that the transfer functions of the processing operators and of the output operators are selected to permit non-linear, especially logarithmic, analogue-digital conversion.

9. Analogue-digital converter according to any one of Claims 1 to 8, characterised in that the processing means comprise at least two levels of operators, the operators of each level being linked to all the operators of the preceding level, and the operators of at least one of those levels being non-linear.

10. Process for analogue-digital conversion, characterised by the following stages:

   a) provide a circuit comprising an analogue signal input (Ve), a reference voltage source (SVR), at least one level of processing operators (N) capable of effecting a non-linear calculation on the basis of their inputs, and a level of output operators (NS), each having as many inputs as there are outputs in the final level of operators of the processing means, each of the said processing operators and output operators possessing its own transfer function,

   b) initialise the transfer functions of the processing operators and of the output operators at selected values,

   c) present a known analogue signal to the said analogue input (Ve),

   d) evaluate by a predetermined distance function (E) the difference between the actual digital output signal and its desired value,

   e) adjust by retropropagation of the gradient the transfer functions of the processing operators and of the output operators in order to minimise that distance function,

   f) repeat selectively stages c) to e) for other values of the analogue input signal, and

   g) fix the transfer functions of the processing operators and of the output operators in order to minimise the distance functions on all of the analogue input signals presented.

11. Process according to Claim 10, characterised in that the said transfer functions comprise the effecting of a weighted combination of their inputs, and the transformation of that weighted combination by a continuous and differentiable function, and in that stage e) is restricted to the adjustment of the weighting coefficients.

12. Process according to Claim 11, characterised in that the said transformation function is determined by operational amplifier fabrication technology.

## FIG.1

SVR — REF

SNS

$p = 2^{n-1}$

## FIG.2A

$$A = \sum_{i=1}^{n} X_i * W_i$$

$F(A)$

## FIG.2B

*FIG.3*

*FIG.4*

NIVEAU 0     NIVEAU 1     NIVEAU S

# FIG.5

# FIG.6

| W (00-13) | -3.80 |
|-----------|-------|
| W (00-12) | -0.97 |
| W (00-11) | -4.84 |
| W (10-S1) | -2.64 |
| W (10-S2) | -2.50 |
| W (01-13) | 12.69 |
| W (01-12) | 9.73 |
| W (01-11) | 9.62 |
| W (13-S1) | -5.40 |
| W (13-S2) | 4.96 |
| W (12-S1) | 5.35 |
| W (12-S2) | 0.03 |
| W (11-S1) | 5.62 |
| W (11-S2) | 1.98 |

FIG.7

NIVEAU 0 | NIVEAU 1 | NIVEAU "S"

EP 0 543 730 B1

## FIG.8

droite optimale
$y = a*x + b$

$$E = \sum_{i=1}^{n} (yi-(a*xi+b))^2$$

## FIG.9

$$a_{après} = a_{avant} - \varepsilon \frac{\Delta E}{\Delta a}$$

$$\frac{\Delta E}{\Delta a} = 0$$

# FIG.10

$$X_i = F(\sum_j W_{ij} * X_j + W_{REF})$$

$$X_k = X_s$$

$$e_i = F'(A_i) \sum_k W_{ki} e_k$$

$$W_{ij\,après} = W_{ij\,avant} - \mathcal{E} e_i X_j$$

| COUCHE D'ENTREE | COUCHE CACHEE 1 | COUCHE CACHEE 2 | COUCHE DE SORTIE | SORTIE DESIREE |

RETROPROPAGATION

EP 0 543 730 B1

## FIG.11

## FIG.13

# FIG.12

SORTIES DESIREES

S1 S2 S3

0 0 0 0 1 1 1 1

0 0 1 1 1 1 0 0

0 1 1 0 0 1 1 0

—— SORTIE DISCRETE
=S1*1+S2*2+S3*4

—— ENTREE CONTINUE $\Rightarrow$

ENTREE

REPONSE D'UN CAN 3 BITS

EP 0 543 730 B1